# EUROPÄISCHE PATENTSCHRIFT

(11) **EP 3 213 610 B1**
(45) Veröffentlichungstag und Bekanntmachung des Hinweises auf die Patenterteilung: **19.08.2020**
(21) Anmeldenummer: 15781868.3
(22) Anmeldetag: 13.10.2015
(51) Int. Cl.: H05K 7/20

(54) **ELEKTROGERÄT, INSBESONDERE UMRICHTER, INSBESONDERE UMRICHTER ZUR SPEISUNG EINES EIN GETRIEBE ANTREIBENDEN ELEKTROMOTORS**
ELECTRICAL DEVICE, IN PARTICULAR A CONVERTER, IN PARTICULAR A CONVERTER FOR SUPPLYING AN ELECTRIC MOTOR WHICH DRIVES A GEARBOX
APPAREIL ÉLECTRIQUE, EN PARTICULIER CHANGEUR DE FRÉQUENCE, EN PARTICULIER CHANGEUR DE FRÉQUENCE POUR ALIMENTER UN MOTEUR ÉLECTRIQUE ENTRAÎNANT UNE TRANSMISSION

(30) Priorität: 28.10.2014 DE 102014015827
(43) Veröffentlichungstag der Anmeldung: 06.09.2017
(73) Patentinhaber: SEW-EURODRIVE GmbH & Co. KG, 76646 Bruchsal (DE)
(72) Erfinder: ILLERHAUS, Edmund, 88368 Bergatreute (DE)
(86) Internationale Anmeldenummer: PCT/EP2015/002014
(87) Internationale Veröffentlichungsnummer: WO 2016/066246

(56) Entgegenhaltungen:
- EP-A2- 2 328 390
- WO-A1-2014/033382
- DE-A1-102010 056 010
- US-A1- 2003 067 748
- US-A1- 2009 168 358
- US-A1- 2009 294 195
- US-A1- 2012 325 447

## Beschreibung

Die Erfindung betrifft einen Antrieb, umfassend ein Elektrogerät, also Umrichter, und ein Getriebe und einen Elektromotor.

Es ist allgemein bekannt, dass Wärme von einem wärmeerzeugenden Bauelement über einen Kühlkörper an die Umgebung abführbar ist.

Aus der US 2012 / 325447 A1 ist als nächstliegender Stand der Technik ein Kühlsystem bekannt.

Aus der DE 10 2010 056 010 A1 ist ein Doppelgehäuse und eine Anordnung zur Aufnahme von elektrischen Bauteilen und ein Verfahren zur Kühlung bekannt.

Aus der US 2009 / 168 358 A1 ist eine Leistungsantriebseinheit bekannt.

Aus der EP 2 328 390 A2 ist ein Umrichter mit einem Kühlkörper bekannt.

Aus der WO 2014/033 382 A1 ist ein Federelement bekannt.

Aus der US 2009/0294195 A1 ist eine Leistungssteuerungseinheit bekannt.

Aus der US 2003/0067748 A1 ist ein wassergekühlter Wechselrichter bekannt.

Der Erfindung liegt daher die Aufgabe zugrunde, die Entwärmung bei einem Antrieb zu verbessern.

Erfindungsgemäß wird die Aufgabe bei dem Antrieb nach den in Anspruch 1 angegebenen Merkmalen gelöst.

Von Vorteil ist dabei, dass vom Bauelement zum Kühlmittel der Wärmestrom des Bauelements nur durch das Gehäuseteil hindurchfließen muss. Somit ist eine effiziente Entwärmung erreichbar. Darüber hinaus ist vorteilhafterweise das Kühlmittel an der Außenseite des Gehäuseteils vorsehbar und das Bauelement an der Innenseite des Gehäuseteils. Somit ist eine möglichst geringe Wegstrecke vom Wärmestrom zurückzulegen. Trotzdem sind Kühlmittel und elektronisches Bauelement sicher getrennt, so dass auch im Falle einer undichten Schlauch- oder Rohrverbindung keine Kontamination der Elektronik stattfindet.

Erfindungsgemäß ist im Kanal Kühlmittel angeordnet, wobei das Kühlmittel Öl ist,
wobei als Öl Schmieröl eines Getriebes verwendet ist, das von einem vom Elektrogerät, insbesondere Umrichter, gespeisten Elektromotors angetrieben wird. Von Vorteil ist dabei, dass das Schmieröl des Getriebes zur Entwärmung des Elektrogeräts verwendbar ist. Somit ist vorteiligerweise das Getriebe und das Elektrogerät an einen Kühlmittelkreislauf anschließbar, der von einer Pumpe antreibbar ist und von einem Ölkühler entwärmbar, wobei die Pumpe und der Ölkühler angeschlossen sind an dem Kühlmittelkreislauf. Auf diese Weise ist nur ein einziger Ölkühler für das Getriebe und das Elektrogerät notwendig. Der Wärmetauscher ist somit zweiteilig ausgeführt, insbesondere mit Gehäusedeckel und Deckelteil.

Bei einer vorteilhaften Ausgestaltung ist das Gehäuseteil und/oder das Deckelteil als Gussteil gefertigt,
insbesondere wobei das Gehäuseteil kastenförmig ausgeformt ist. Von Vorteil ist dabei, dass das Teil ohne Fugen oder dergleichen fertigbar ist sondern das Teil einstückig und einteilig fertigbar sind, insbesondere als Gussteile.

Bei einer vorteilhaften Ausgestaltung sind das Gehäuseteil und das Deckelteil aus demselben Material gefertigt, insbesondere aus derselben Legierung. Von Vorteil ist dabei, dass thermisch bedingte Ausdehnungen die Dichtigkeit der Verbindung zwischen Deckelteil und Gehäuseteil nicht gefährden. Somit ist das Kühlmittel im Kanal zwischen Gehäuseteil und Deckelteil eingeordnet, ohne dass eine Leckage bewirkt ist.

Bei einer vorteilhaften Ausgestaltung weist das Deckelteil eine den Kanal begrenzende, glatte, insbesondere also stetig differenzierbare, Oberfläche auf, insbesondere keine Ecken aufweist,
und/oder
die Kanalwandung des Deckelteils weist an ihrer dem Gehäuseteil zugewandten Seite ein Bogenstück, beispielsweise ein Kreisbogenstück oder ein Ellipsenbogenstück, als Querschnitt auf. Von Vorteil ist dabei, dass das Kühlmittel unter hohem Druck vorsehbar ist. Denn durch die glatte beziehungsweise eckenfreie Ausführung ist eine hohe Druckbelastung des Deckelteils zulässig.

Bei einer vorteilhaften Ausgestaltung sind die Kühlrippen beziehungsweise Kühlfinger vom Deckelteil beabstandet. Von Vorteil ist dabei, dass am Kanalboden auch eine Querströmung bewirkbar ist und somit eine verbesserte Durchmischung des Kühlmittels. Turbulatoren sind somit entbehrlich.

Bei einer vorteilhaften Ausgestaltung weist das Deckelteil einen Einlassbereich auf, in welchen der Kanal mündet,
und/oder weist das Deckelteil einen Auslassbereich auf, in welchen der Kanal mündet. Von Vorteil ist dabei, dass eine Hydraulikleitung an das Deckelteil anschließbar ist. Insbesondere ist eine Hydraulikleitung an den Einlassbereich anschließbar und eine Hydraulikleitung an den Auslassbereich.

Bei einer vorteilhaften Ausgestaltung weisen die Kühlfinger und/oder die Kühlrippen eine zum Deckelteil hin gerichtete Verjüngung auf. Von Vorteil ist dabei, dass ein verbesserter Wärmeübergang bewirkbar ist.

Bei einer vorteilhaften Ausgestaltung verläuft der Kanal insbesondere mäanderförmig an der zum Gehäuseteil zugewandten Seite des Deckelteils,

insbesondere wobei der Kanal als Vertiefung im Deckelteil ausgebildet ist. Von Vorteil ist dabei, dass eine weiter verbesserte Entwärmung erreichbar ist.

Bei einer vorteilhaften Ausgestaltung ist das Gehäuseteil an seiner vom Deckelteil abgewandten Seite mit einem weiteren Deckelteil dicht verbunden, so dass das Bauelement gehäusebildend vom Deckelteil und vom Gehäuseteil umgeben ist. Von Vorteil ist dabei, dass

Bei einer vorteilhaften Ausgestaltung weist das Gehäuseteil eine Ausnehmung auf, wobei die Ausnehmung von einer Kabeldurchführung oder von einem Steckverbinderteil verschlossen ist, welche dicht verbunden ist mit dem Gehäuseteil, wobei die Ausnehmung von dem Deckelteil beabstandet ist, insbesondere wobei die Ausnehmung auf der von den Kühlrippen oder Kühlfingern gesehen abgewandten Seite des Gehäuseteils angeordnet ist, insbesondere wobei die Ausnehmung vom Boden des kastenförmigen Gehäuseteils beabstandet ist. Von Vorteil ist dabei, dass eine hohe Schutzart des Gehäuses erreichbar ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:

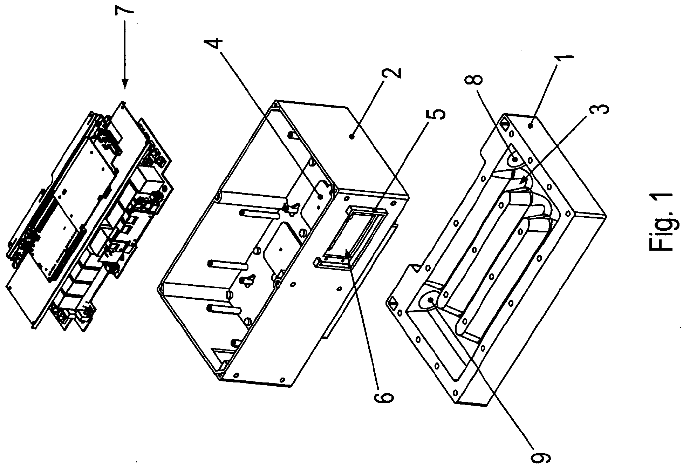

In der Figur 1 ist ein erfindungsgemäßes Elektrogerät, insbesondere Umrichter, in explodierter Darstellung in Schrägansicht dargestellt.

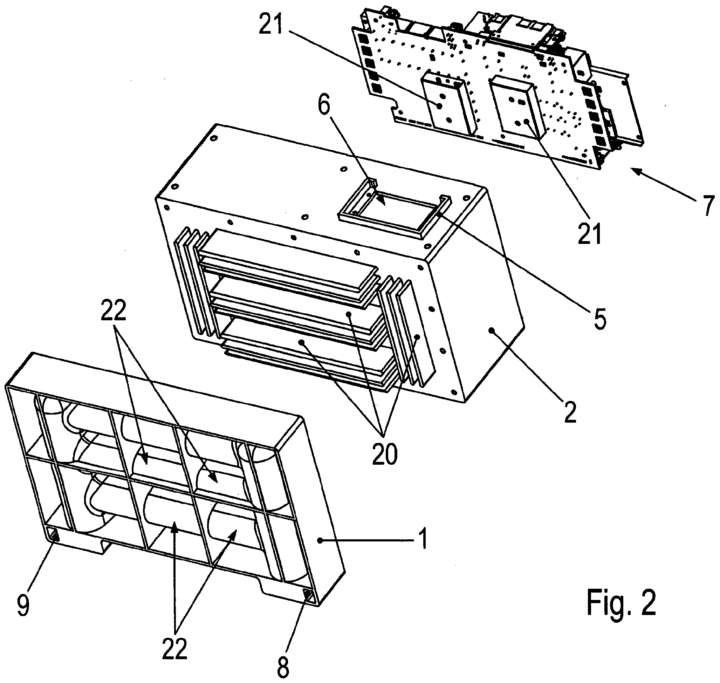

In der Figur 2 ist eine zugehörige Ansicht aus anderer Blickrichtung gezeigt.
In der Figur 3 ist eine angeschnittene Darstellung des Elektrogeräts dargestellt.

Wie in den Figuren gezeigt, weist das Elektrogerät ein kastenförmiges Gehäuseteil 2 auf, welches einstückig ausgeführt ist.

Das Gehäuseteil 2 ist aus Metall, insbesondere umfassend Aluminium, gefertigt.

An der Innenseite des Kastenbodens des Gehäuseteil 2 ist eine Erhebung vorgesehen, die eine fein bearbeitete, eben ausgeformte Kontaktfläche 4 aufweist.

Eine in den Kasten eingesetzte Elektronikbaugruppe 7, insbesondere Leistungselektronik, weist ein wärmeerzeugendes Element 21, insbesondere Leistungshalbleiter, auf, der an die Kontaktfläche 4 angedrückt wird, so dass ein geringer Wärmeübergangswiderstand vom Element 21 zur Kontaktfläche 4 und somit zum Gehäuseteil 2 vorhanden ist.

Eine weitere Reduzierung des Wärmeübergangswiderstands ist durch das Einbringen von Wärmeleitpaste oder eine entsprechende Wärmeleitfolie erreichbar, die zwischen das Element 21 und die Kontaktfläche 4 angeordnet wird.

An seiner Außenseite weist das Gehäuseteil 2 Kühlrippen 20 auf.

Ein Deckelteil 1, insbesondere Kühldeckelteil, ist auf diejenige Seite des Gehäuseteils 2 aufgesetzt und dicht mit diesem verbunden, welche die Kühlrippen 20 aufweist. Somit sind die Kühlrippen 20 vom Deckelteil 1 abgedeckt, insbesondere gehäusebildend umgeben.

Die Verbindung zwischen Deckelteil 1 und Gehäuseteil 2 ist derart dicht ausgeführt, dass im die Kühlrippen 20 aufnehmenden Innenraumbereich ein Überdruck gegen den Umgebungsluftdruck vorsehbar ist. Beispielsweise ist ein Überdruck von mehr als 4 bar, insbesondere von mehr als 8 bar zulässig.

In dem die Kühlrippen 20 aufnehmenden Innenraumbereich ist ein Kühlmittel vorgesehen, so dass dieses die Wärme von den Kühlrippen des Gehäuseteils 2 aufnimmt.

Der Innenraumbereich ist aus Kanälen 3 zusammengesetzt, in welche die Kühlrippen 20 hineinragen. Die Kanäle 3 sind entweder zwischen einem Einlassbereich (8) und einem Auslassbereich (8) des Deckelteils 1 parallel angeordnet, werden also gleichsinnig durchströmt, so dass sie jeweils ein gleichförmiges Temperaturgefälle aufweisen, oder alternativ sind die Kanäle 3-mäanderförmig hintereinander angeordnet, so dass das Kühlmittel mäanderförmig die Kanäle 3 durchströmt.

Eine außerhalb angeordnete Pumpe fördert das Kühlmittel durch ein Leitungssystem, so dass das Kühlmittel im Einlassbereich (8) des Deckelteil 1 in den Innenraum einströmt und aus dem Auslassbereich (8) des Deckelteils 1 ausströmt.

Das Deckelteil 1 ist aus Metall gefertigt. Vorzugswiese wird hierbei dasselbe Material verwendet, welches auch für die Herstellung des Gehäuseteils 2 ausgewählt ist. Beispielsweise werden also für das Gehäuseteil 2 und das Deckelteil 1 dieselben Legierungen verwendet. Somit sind die thermischen Ausdehnungen der beiden Teile gleichförmig und die Dichtigkeit ist auch bei hohem Druck in einfacher Weise beibehaltbar.

Die Kanäle 3 weisen einen halbbogenförmigen Querschnitt auf. Beispielsweise ist also als Querschnitt ein Halbkreis oder eine halbe Ellipsenfläche vorgesehen.

Entsprechend weist also die Kanalwandung 22 an ihrer dem Gehäuseteil 2 zugewandten Seite ein Bogenstück, beispielsweise einen Halbkreis oder ein Kreisbogenstück oder ein Ellipsenbogenstück, als Querschnitt auf.

Diese konkave Ausgestaltung der Wandung Kanäle 3 bewirkt eine hohe Stabilität des Deckelteils 1 auch bei großem Überdruck. Außerdem ist für die Kanalwandung eine geringe Wandstärke wählbar. Auf diese Weise ist Masse am Deckelteil 1 einsparbar und trotzdem ein hoher Überdruck zulässig.

Die Kanalwandung weist also keine Ecken auf. Sie ist also glatt ausgeführt, also stetig differenzierbar.

Als Kühlmittel ist beispielsweise auch das Schmieröl eines Getriebes verwendbar. Somit ist das Elektrogerät als Umrichter ausführbar, der einen Elektromotor speist, so dass die Drehzahl des Elektromotors steuerbar oder sogar regelbar ist, wobei der Elektromotor ein Getriebe antreibt, dessen Schmieröl als Kühlmittel verwendbar ist.

Somit ist das Getriebe dann an das Leitungssystem angeschlossen, so dass das Schmieröl des Getriebes von der Pumpe aus dem Getriebe herausgefördert wird zum Einlass (8) des Deckelteils 1 und aus dem Auslass (8) des Deckelteils 1 wieder zum Getriebe.

Zusätzlich ist im Leitungssystem auch ein Ölkühler, wie Radiator, angeordnet Auf diese Weise ist dann das Getriebe und das Elektrogerät entwärmbar.

Bei einer Weiterbildung ist auch der Elektromotor vom Kühlmedium durchströmt. Hierzu weist ein Gehäuseteil des Elektromotors einen Kanal auf, der vom Kühlmedium durchströmbar ist, und ist mit dem Leitungssystem verbunden, so dass der Kanal des Gehäuseteils durchströmt ist vom Kühlmittel.

Auf diese Weise ist der gesamte Antrieb, umfassend Umrichter, Getriebe und Elektromotor, vom Kühlmittel durchströmt und entwärmt.

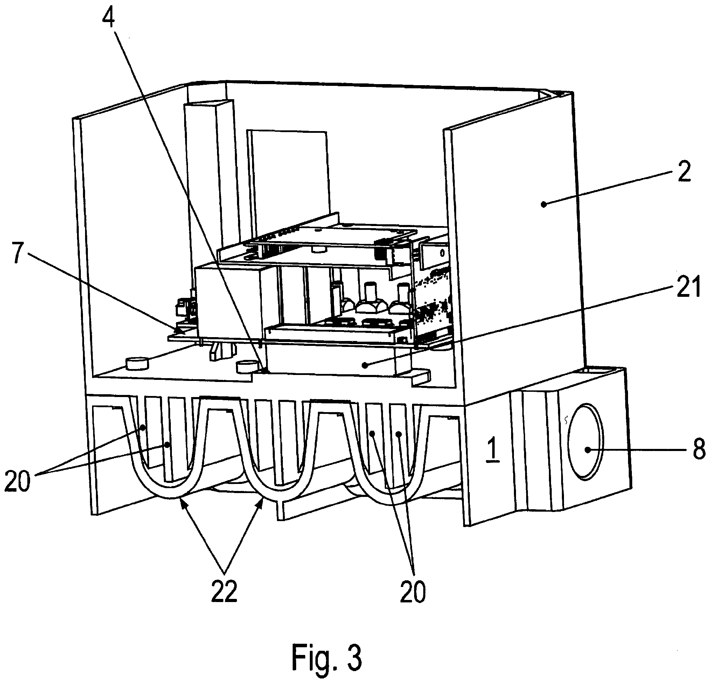

Wie in Figur 3 gezeigt, sind die Kühlrippen 20 derart angeordnet, dass in Querrichtung zur Kanalrichtung in den jeweiligen Kanal nicht nur eine einzige Kühlrippe 20, sondern mehrere Kühlrippen 20 hineinragen. Dabei sind die Kühlrippen 20 stets beabstandet vom Boden des Kanals 3. Eine zum Kanalboden hin gerichtete Verjüngung der Kühlrippen 20 ist vorteilhaft. Dabei sind nur die außen in Querrichtung zur Kanalrichtung angeordneten Kühlrippen 20 mit einer solchen Verjüngung ausgeführt.

Bevorzugt bildet das Elektrogerät, insbesondere Umrichter, eine bauliche Einheit mit dem Getriebe und dem Elektromotor. Weiter bevorzugt ist ein Gehäuse, insbesondere Blechgehäuse, vorgesehen, das den Umrichter, das Getriebe und den Elektromotor zumindest teilweise einhaust.

Die Oberseite des Gehäuseteils 2 ist mit einem weiteren Deckelteil verschlossen. Dieses weitere Deckelteil ist aus Kunststoff oder Metall herstellbar. Somit ist die Elektronikbaugruppe 7 gehäusebildend umgeben vom Gehäuseteil 1 zusammen mit dem auf diesem Gehäuseteil 1 aufgesetzten weiteren Deckelteil.

Besonders vorteilhaft ist, dass der vom Wärme erzeugenden Element 21 erzeugte Wärmestrom nur mittels zweier Verbindungsstellen zum Kühlmittel gelangt. Hierzu ist am Gehäuseteil 2 die Kontaktfläche 4 vorgesehen und die jeweilige Kühlrippe 20 ragt in den jeweiligen Kanal 3 hinein. Auf diese Weise muss der Wärmestrom also nur durch das Gehäuseteil 2 zum Kühlmittel. Durch diese minimale Anzahl von Wärmeübergängen ist ein besonders niedriger Wärmeleitwiderstand entlang des Wärmestrompfads erreichbar.

Bei Leckage einer Dichtung tritt zwar Kühlmittel zwischen Deckelteil 1 und Gehäuseteil 2 aus, jedoch ist die Funktion der Elektronik, welche sich im Inneren des kastenförmigen Gehäuseteils 2 befindet, nicht gestört. Denn das Gehäuseteil 2 ist einstückig ausgeführt und weist daher keine gegenüber dem Kühlmittel abzudichtende Stelle, insbesondere Dichtstelle, auf. Die Elektronik befindet sich also in einem geschützten abgeschlossenen Volumen, wobei das weitere Deckelteil nur dicht verbunden wird. Eine Dichtung gegen überdruck ist hierbei nicht notwendig.

Das Gehäuseteil 2 ist als Gussteil hergestellt. Somit ist es fugenfrei und dicht herstellbar.

Bei einem weiteren erfindungsgemäßen Ausführungsbeispiel sind die Kühlrippen 20 durch Kühlfinger, also stiftförmig ausgeformte Bereiche, ersetzt, so dass die Strömung des Kühlmittels mehr Wirbel aufweist und somit ein weiter verbesserter Abtransport der Wärme durch das Kühlmittel erreichbar ist. Denn die Kühlfinger rage in die Kanäle hinein und sind somit vom Kühlmittel umströmt.

### Bezugszeichenliste

1 Deckelteil, insbesondere Kühldeckelteil
2 Gehäuseteil
3 Kanal für Kühlmittel
4 Kontaktfläche
5 Dichtungswulst
6 Ausnehmung
7 Elektronikbaugruppe, insbesondere Leistungselektronik
8 Einlass
9 Auslass
20 Kühlrippen
21 Wärme erzeugendes Element, insbesondere Leistungshalbleiter
22 halbbogenförmige Kanalwandung

## Patentansprüche

1. Antrieb, umfassend ein Elektrogerät, also Umrichter, und ein Getriebe und einen Elektromotor,
wobei das Elektrogerät als Umrichter zur Speisung eines ein Getriebe antreibenden Elektromotors ausgeführt ist,
wobei das Elektrogerät ein Gehäuseteil (2), ein Deckelteil (1) und ein wärmeerzeugendes Bauelement (21), insbesondere Leistungshalbleiter, aufweist,
wobei das Gehäuseteil (2) an seiner Außenseite Kühlrippen (20) und/oder Kühlfinger aufweist, die in einen Kanal (3) hineinragen, der in einem Deckelteil (1), insbesondere als Vertiefung, ausgebildet und/oder ausgeformt, ist,
wobei das Deckelteil (1) mit dem Gehäuseteil (2) dicht, insbesondere druckdicht, verbunden ist, so dass der Kanal (3) zwischen dem Gehäuseteil (2) und dem Deckelteil (1) angeordnet ist,
wobei das Bauelement (21) angedrückt ist, insbesondere von einem Federelement, gegen die Innenseite des Gehäuseteils, insbesondere gegen eine an der Innenseite des Gehäuseteils ausgeformte Kontaktfläche (4),
wobei im Kanal (3) Kühlmittel angeordnet ist,
wobei das Kühlmittel Öl ist,
wobei als Öl Schmieröl des Getriebes verwendet ist, das von dem vom Elektrogerät gespeisten Elektromotors angetrieben wird.

2. Antrieb nach Anspruch 1,
**dadurch gekennzeichnet, dass**
das Gehäuseteil (2) und/oder das Deckelteil (1) als Gussteil gefertigt ist,
insbesondere wobei das Gehäuseteil (2) kastenförmig ausgeformt ist.

3. Antrieb nach mindestens einem der vorangegangenen Ansprüche,
**dadurch gekennzeichnet, dass**
das Gehäuseteil (2) und das Deckelteil (1) aus demselben Material gefertigt sind, insbesondere aus derselben Legierung.

4. Antrieb nach mindestens einem der vorangegangenen Ansprüche,
**dadurch gekennzeichnet, dass**
das Deckelteil (1) eine den Kanal (3) begrenzende, glatte, insbesondere also stetig differenzierbare, Oberfläche aufweist, insbesondere keine Ecken aufweist,
und/oder dass
die Kanalwandung (22) des Deckelteils (1) an ihrer dem Gehäuseteil (2) zugewandten Seite ein Bogenstück, beispielsweise ein Kreisbogenstück oder ein Ellipsenbogenstück, als Querschnitt auf.

5. Antrieb nach mindestens einem der vorangegangenen Ansprüche,
**dadurch gekennzeichnet, dass**
die Kühlrippen (20) beziehungsweise Kühlfinger vom Deckelteil (1) beabstandet sind.

6. Antrieb nach mindestens einem der vorangegangenen Ansprüche,
**dadurch gekennzeichnet, dass**
das Deckelteil (1) einen Einlassbereich (8) aufweist, in welchen der Kanal (3) mündet
und/oder dass
das Deckelteil (1) einen Auslassbereich (9) aufweist, in welchen der Kanal (3) mündet.

7. Antrieb nach mindestens einem der vorangegangenen Ansprüche,
**dadurch gekennzeichnet, dass**
die Kühlfinger und/oder die Kühlrippen (20) eine zum Deckelteil (1) hin gerichtete Verjüngung aufweisen.

8. Antrieb nach mindestens einem der vorangegangenen Ansprüche,
**dadurch gekennzeichnet, dass**
der Kanal (3) insbesondere mäanderförmig an der zum Gehäuseteil (2) zugewandten Seite des Deckelteils (1) verläuft,
insbesondere wobei der Kanal (3) als Vertiefung im Deckelteil (1) ausgebildet ist.

9. Antrieb nach mindestens einem der vorangegangenen Ansprüche,
**dadurch gekennzeichnet, dass**
das Gehäuseteil (2) an seiner vom Deckelteil (1) abgewandten Seite mit einem weiteren Deckelteil (1) dicht verbunden ist, so dass das Bauelement (21) gehäusebildend vom Deckelteil (1) und vom Gehäuseteil (2) umgeben ist.

10. Antrieb nach mindestens einem der vorangegangenen Ansprüche,
**dadurch gekennzeichnet, dass**
das Gehäuseteil (2) eine Ausnehmung aufweist, wobei die Ausnehmung von einer Kabeldurchführung oder von einem Steckverbinderteil verschlossen ist, welche dicht verbunden ist mit dem Gehäuseteil (2),
wobei die Ausnehmung von dem Deckelteil (1) beabstandet ist, insbesondere wobei die Ausnehmung auf der von den Kühlrippen (20) oder Kühlfingern gesehen abgewandten Seite des Gehäuseteils (2) angeordnet ist, insbesondere wobei die Ausnehmung vom Boden des kastenförmigen Gehäuseteils (2) beabstandet ist.

## Claims

1. A drive, comprising an electrical device, therefore converter, and a gear unit and an electric motor,
wherein the electrical device is in the form of a converter for supplying an electric motor driving a gear unit,
wherein the electrical device has a housing part (2), a cover part (1) and a heat-generating component part (21), in particular power semiconductor,
wherein the exterior of the housing part (2) has cooling ribs (20) and/or cooling fingers, which project into a channel (3) constructed and/or formed in a cover part (1), in particular as a depression,
wherein the cover part (1) is connected to the housing part (2) in an impervious manner, in particular in a pressure-tight manner, so that the channel (3) is arranged between the housing part (2) and the cover part (1),
wherein the component part (21) is pressed, in particular by a spring element, against the inner side of the housing part, in particular against a contact surface (4) formed at the inner side of the housing part,
wherein a cooling means is arranged in the channel (3),
wherein the cooling means is oil,
wherein lubricating oil of the gear unit is used as oil, which gear unit is driven by the electric motor supplied by the electrical device.

2. A drive according to claim 1,
**characterized in that**
the housing part (2) and/or the cover part (1) is/are manufactured as a cast part,
in particular wherein the housing part (2) is box-shaped.

3. A drive according to at least one of the preceding claims,
**characterised in that**
the housing part (2) and the cover part (1) are manufactured from the same material,
in particular from the same alloy.

4. A drive according to at least one of the preceding claims,
**characterised in that**
the cover part (1) has a smooth, in particular therefore continuously differentiable, surface bounding the channel (3), in particular does not have any corners,
and/or **in that**
the channel wall (22) of the cover part (1) [has] a curved part, for example a circular arc part or an elliptical arc part, as cross-section at its side facing the housing part (2).

5. A drive according to at least one of the preceding claims,
**characterised in that**
the cooling ribs (20) and/or cooling fingers are at a distance from the cover part (1).

6. A drive according to at least one of the preceding claims,
**characterised in that**
the cover part (1) has an inlet region (8) into which the channel (3) opens and/or **in that**
the cover part (1) has an outlet region (9) into which the channel (3) opens.

7. A drive according to at least one of the preceding claims,
**characterised in that**
the cooling fingers and/or the cooling ribs (20) have a taper directed towards the cover part (1).

8. A drive according to at least one of the preceding claims,
**characterised in that**
the channel (3) runs in particular in a meander-shaped manner at the side, facing the housing part (2), of the cover part (1),
in particular wherein the channel (3) is in the form of a depression in the cover part (1).

9. A drive according to at least one of the preceding claims,
**characterised in that**
the housing part (2) is connected in an impervious manner to a further cover part (1) at its side remote from the cover part (1), so that the component part (21) is surrounded in a housing-forming manner by the cover part (1) and by the housing part (2).

10. A drive according to at least one of the preceding claims,
**characterised in that**
the housing part (2) has an opening, wherein the opening is closed by a cable bushing or by a plug-and-socket connector part, which is connected in an impervious manner to the housing part (2),
wherein the opening is at a distance from the cover part (1), in particular wherein the opening is arranged on the side, remote viewed from the cooling ribs (20) or cooling fingers, of the housing part (2), in particular wherein the opening is at a distance from the bottom of the box-shaped housing part (2).

## Revendications

1. Entraînement, comprenant un appareil électrique, à savoir un variateur, une transmission et un moteur électrique,
dans lequel l'appareil électrique est réalisé sous la forme d'un variateur destiné à alimenter un moteur électrique entraînant une transmission,
dans lequel l'appareil électrique présente une partie boîtier (2), une partie couvercle (1) et un composant produisant de la chaleur (21), en particulier un semi-conducteur de puissance,
dans lequel la partie boîtier (2) présente sur son côté extérieur des ailettes de refroidissement (20) et/ou des doigts de refroidissement qui font saillie dans un canal (3) qui est réalisé et/ou formé dans une partie couvercle (1), en particulier sous la forme d'un renfoncement,
dans lequel la partie couvercle (1) est reliée à la partie boîtier (2) de manière étanche, en particulier de manière étanche à la pression, de telle sorte que le canal (3) est disposé entre la partie boîtier (2) et la partie couvercle (1),
dans lequel le composant (21) est pressé, en particulier par un élément à ressort, contre le côté intérieur de la partie boîtier, en particulier contre une surface de contact (4) formée sur le côté intérieur de la partie boîtier,
dans lequel un liquide de refroidissement est disposé dans le canal (3),
dans lequel le liquide de refroidissement est de l'huile,
dans lequel l'huile utilisée est l'huile de lubrification de la transmission qui est entraînée par le moteur électrique alimenté par l'appareil électrique.

2. Entraînement selon la revendication 1,
**caractérisé en ce que**
la partie boîtier (2) et/ou la partie couvercle (1) sont fabriquées sous la forme de pièces moulées,
en particulier dans lequel la partie boîtier (2) est réalisée en forme de caisson.

3. Entraînement selon au moins l'une des revendications précédentes,
**caractérisé en ce que**
la partie boîtier (2) et la partie couvercle (1) sont fabriquées dans le même matériau, en particulier dans le même alliage.

4. Entraînement selon au moins l'une des revendications précédentes,
**caractérisé en ce que**
la partie couvercle (1) présente une surface lisse, en particulier donc continûment différentiable, délimitant le canal (3), en particulier ne présente pas d'angles,
et/ou que
la paroi de canal (22) de la partie couvercle (1) présente, sur son côté tourné vers la partie boîtier (2), une pièce en arc, par exemple une pièce en arc de cercle ou une pièce en arc d'ellipse, en section transversale.

5. Entraînement selon au moins l'une des revendications précédentes,
**caractérisé en ce que**
les ailettes de refroidissement (20) ou les doigts de refroidissement sont espacé(e)s de la partie couvercle (1).

6. Entraînement selon au moins l'une des revendications précédentes,
**caractérisé en ce que**
la partie couvercle (1) présente une zone d'entrée (8) dans laquelle débouche le canal (3)
et/ou que
la partie couvercle (1) présente une zone de sortie (9) dans laquelle débouche le canal (3).

7. Entraînement selon au moins l'une des revendications précédentes,
**caractérisé en ce que**
les doigts de refroidissement et/ou les ailettes de refroidissement (20) présentent un rétrécissement dirigé vers la partie couvercle (1).

8. Entraînement selon au moins l'une des revendications précédentes,
**caractérisé en ce que**
le canal (3) s'étend en particulier en méandres sur le côté de la partie couvercle (1) tourné vers la partie boîtier (2),
en particulier dans lequel le canal (3) est réalisé sous la forme d'un renfoncement dans la partie couvercle (1).

9. Entraînement selon au moins l'une des revendications précédentes,
**caractérisé en ce que**
la partie boîtier (2) est reliée de manière étanche à une autre partie couvercle (1) sur son côté opposé à la partie couvercle (1), de telle sorte que le composant (21) est entouré à la manière d'un boîtier par la partie couvercle (1) et la partie boîtier (2).

10. Entraînement selon au moins l'une des revendications précédentes,
**caractérisé en ce que**
la partie boîtier (2) présente un évidement, dans lequel l'évidement est fermé par un passe-câble ou par une partie de connecteur qui est reliée de manière étanche à la partie boîtier (2),
dans lequel l'évidement est espacé de la partie couvercle (1), en particulier dans lequel l'évidement est disposé sur le côté opposé de la partie boîtier (2), vu depuis les ailettes de refroidissement (20) ou les doigts de refroidissement, en particulier dans lequel l'évidement est espacé du fond de la partie boîtier (2) en forme de caisson.
